# EUROPEAN PATENT APPLICATION

(11) **EP 0 962 776 A2**
(43) Date of publication of application: **08.12.1999**
(21) Application number: 98114029.6
(22) Date of filing: 27.07.1998
(51) Int. Cl.: G01R 1/073

(54) **Probe card suitable for inspection of multi-pin devices**

(30) Priority: 02.06.1998 JP 16779298
(71) Applicant: Advantest Corporation, Nerima-ku, Tokyo 179-0071 (JP)
(72) Inventor: Kojima, Akio, c/o Advantest Corporation, Tokyo 179-0071 (JP)
(74) Representative: von Bülow, Tam, Dr.

(57) **Abstract**

The probe card suitable for inspection of multi-pin devices comprises a plurality of probe pins, each having a tip which comes into contact with one of electrical terminals of a semiconductor device, an elastic member causing the tip of each probe pin to spring back in the axial direction of the probe pin when the tip of the probe pin is pressed against the electrical terminal, a plurality of transfer lines for supplying and receiving signals to and from the probe pins when the probe pins are in contact with the terminals, and a substrate for holding the probe pins and the transfer lines. At least some of the plurality of probe pins may be arranged in a straight line on the probe card. The elastic member has a probe-pin shifting mechanism for moving the tip of each probe pin in a direction perpendicular to the axial direction of the probe pin a distance corresponding to the distance the probe pin moves in the vertical direction when the tip of the probe pin is pressed against the terminal. The probe-pin shifting mechanism may move the tip of each probe pin in a predetermined direction when the tip of the probe pin is pressed against the terminal. If at least some of the plurality of probe pins are aligned in a straight line on the probe card, the predetermined direction is perpendicular to both the axial direction of the probe pin and the straight line in which the probe pins are arranged.

## Description

### BACKGROUND OF THE INVENTION

### 1. Field of Invention

This invention relates to a probe card for testing the electrical properties of semiconductor integrated circuits, such as IC chips, LSI chips and memories, and more particularly to a probe card which can quickly test multi-pin semiconductors.

### 2. Description of Related Art

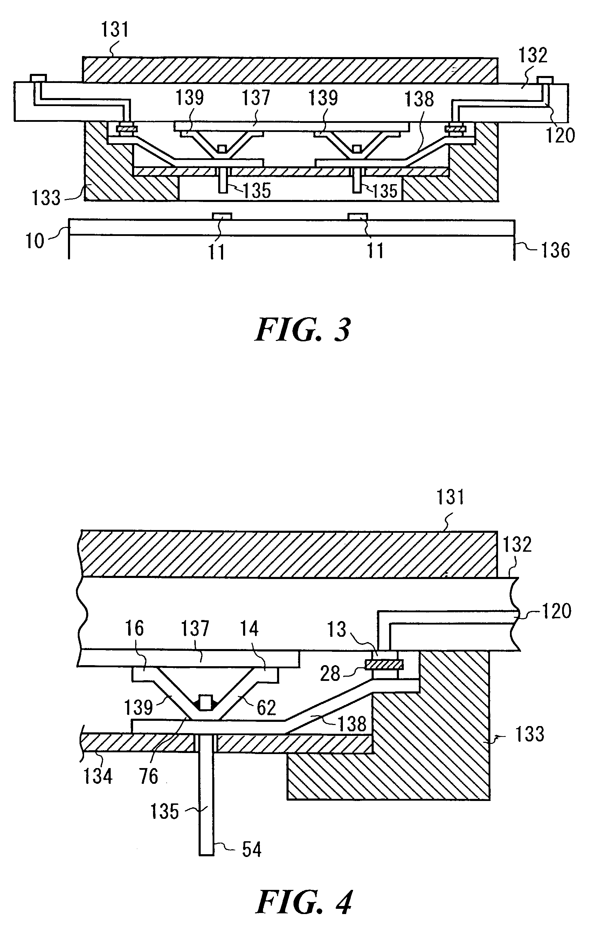

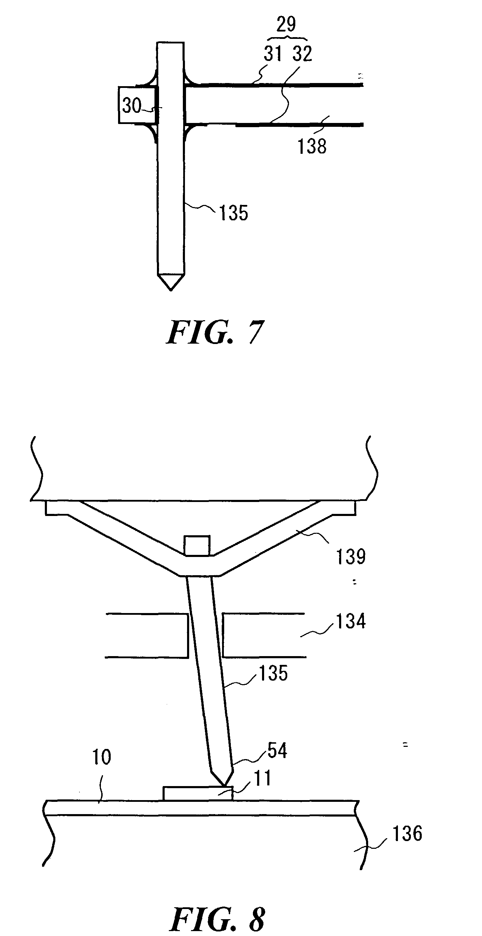

Probe cards are generally used to test the electrical properties of semiconductor integrated circuits, such as IC chips and LSI chips. An article by (First name) Asakura published in Nikkei Microdevices, September 1996 discloses the structures of a conventional cantilever type probe card and a membrane type probe card in its Fig. 4 and the relevant explanation. Asakura's Fig. 7 and the relevant explanation also indicate that the probe pins of a conventional probe card sometimes rub against the electric terminals of the semiconductor integrated circuit being tested. Asakura's Fig. 8 and the relevant explanation disclose variations of a conventional probe pin. Another article by Asakura published in Nikkei Microdevices, July 1996 indicates that it is desirable for a probe pin to rub against the electrodes at 112, right column, and that it is desirable for a probe pin to be short at 113, left column.

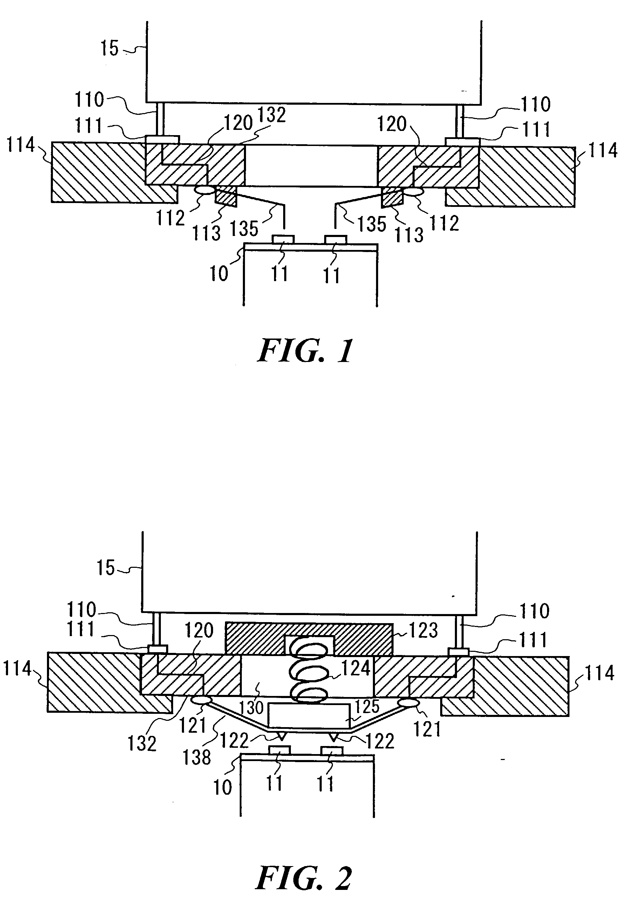

Fig. 1 illustrates the basic structure of a conventional cantilever type probe card for testing a semiconductor device 10, such as an IC chip or an LSI chip. The cantilever type probe card has a test head 15, pogo pins 110, pads 111 connected to the test head 15 via the pogo pins 110, a flat printed circuit board 132 on which the pads 111 are mounted, and a holder 114 for holding the printed circuit board 132. The bottom face of the printed circuit board 132, which faces the semiconductor device 10 being tested, is provided with pads 112, probe pins 135 made of tungsten and connected to the pads 112, and fixing resin 113 for securing the probe pins 135. When the tips of the probe pins 135 come into contact with the electric terminals 11 formed on the semiconductor device 10, electric signals for testing the electrical property of the semiconductor device 10 are propagated into the semiconductor device 10.

The tips of the probe pins 135 extend in the vertical direction to the electric terminals 11 a predetermined length. In other words, the tips of the probe pins 135 are perpendicular to both the printed circuit board 132 and the top surface of the semiconductor device 10. The probe pins 135 then bend and extend obliquely to the pads 112, and are soldered to the pads 112. The pogo pins 110 are provided on the opposite face (i.e., the top surface) of the printed circuit board 132 via the pads 111 at positions corresponding to the respective pads 112. Each of the pads 111 is electrically connected to one of the pads 112 via an interconnection pattern 120 formed inside the printed circuit board 132. The pads 111 are also connected to the test head 15 via the pogo pins 110. An electric signal is supplied from the test head 15 to the electrical terminals 11 via the pogo pins 110, the pads 111, the interconnection patterns 120, the pads 112, and the probe pins 135.

A cantilever type probe card has a simple structure, and it can be manufactured and shipped in a short period of time. In addition, it has been used in this field for a long time with high reliability. However, the tip position of the probe pin 135 must be aligned by hand and, accordingly, it is difficult to arrange the probe pins 135 at a narrow pitch. Another problem in a conventional cantilever type probe card is that the transmission line from the test head 15 to the printed circuit board 132 has a coaxial structure, while the probe pin 135 has a long non-coaxial structure. For this reason, high-speed signals can not be transferred accurately.

Fig. 2 illustrates the basic structure of a conventional membrane type probe card. The membrane type probe card comprises a flat printed circuit board 132 which has an aperture 130 in the center and faces the semiconductor device 10 being tested. The bottom surface of the printed circuit board 132 is provided with elastic connectors 121, which are connected to a flexible printed circuit board 138 manufactured by photolithography or plating. The flexible printed circuit board 138 has bumps 122 projecting toward the electrical terminals 11 of the semiconductor device 10. The bumps 122 are formed by the same process as the flexible printed circuit board 138, that is, plating or the like.

A disk-like first supporter 123 is fixed to the top surface of the printed circuit board 132. The outer diameter of the first supporter 123 is slightly greater than the diameter of the aperture 130 formed in the printed circuit board 132, and the first supporter 123 is fixed onto the printed circuit board 132 so as to entirely cover the aperture 130. The first supporter 123 has a recess in the center of the bottom surface. The recess faces the flexible printed circuit board 138, and an elastic spring 124 is set in the recess. The spring 124 presses the flexible printed circuit board 138, via a second supporter 125, against the semiconductor device 10. An electric signal is supplied from the test head 15 to the electrical terminals 11 via the pogo pins 110, the pads 111, the interconnection patterns 120, the elastic connectors 121, the flexible printed circuit board 138, and the bumps 122.

The signal-transfer line from the test head 15 to the flexible printed circuit board 138 has a coaxial structure. Although the bump 122 is non-coaxial, a high-speed signal can be transmitted because the bump 122 is sufficiently small and short. Electrodes can be arranged at a narrow pitch in the membrane type probe card to conduct a high-speed test. However, it takes time to manufacture the membrane type probe card because of its structure, and the reliability is low as compared to a cantilever type probe card.

### SUMMARY OF THE INVENTION

Therefore, it is an object of the present invention to provide a probe card and a probe pin which can overcome these problems in the prior art. This object is achieved by combinations of the features described in the attached independent claims. The dependent claims define advantageous modifications of the present invention.

In order to achieve the object, in one aspect of the invention, a probe card for testing a device having a plurality of terminals is provided. This probe card has a plurality of probe pins, each having a tip which comes into contact with one of the terminals of the device being tested, and a plurality of elastic members, each provided to one of the probe pins. Each of the elastic members causes the tip of the associated probe pin to spring back in the axial direction of the probe pin when the tip of the probe pin is pressed against the corresponding terminal. The probe card also has a plurality of transfer lines for supplying and receiving signals to and from the probe pins when the probe pins are in contact with the terminals, and a substrate for holding the probe pins and the transfer lines. At least some of the plurality of probe pins may be arranged in a straight line on the probe card. The probe card may further comprise a probe-pin shifting mechanism for moving the tip of the probe pin in a direction perpendicular to the axial direction of the probe pin a distance corresponding to the distance the probe pin moves vertically when the probe pin is pressed against the corresponding terminal in the axial direction of the probe pin. The shifting mechanism moves the tip of the probe pin in a predetermined direction when the tip of the probe pin is pressed against the terminal along the axial direction of the probe pin. If at least some of the plurality of probe pins are aligned in a straight line on the probe card, the predetermined direction is perpendicular to both the axial direction of the probe pin and the direction of the straight line along which the probe pins are arranged. Each transfer line comprises a signal line having a specific line impedance, and a feedback line extending parallel to the signal line. Alternatively, at least a part of each transfer line may consist of a signal line for supplying an electric signal, and a feedback line connected to the signal line in the vicinity of the probe pin. Each transfer line may be provided independently to one of the probe pins.

The probe-pin shifting mechanism has a guide for supporting the probe pins, each being supported at a position between the tip and the base in a slidable manner, and a plurality of springs, each corresponding to one of the probe pins. The springs are, for example, V-shaped and therefore have three ends, two on top and one on bottom. One of the top ends is a fixed end fixed to the substrate, and the bottom end is a setting end for receiving the base of the probe pin. The setting end shifts in a direction perpendicular to the axial direction of the probe pin when a force is applied to the setting end in the axis direction of the probe pin. The base of the probe pin is fixed to the associated spring. Each spring has a middle portion between the fixed end and the setting end, which stretches in the axial direction of the probe pin. The second top end of each spring, which is opposite the fixed end, is a sliding end which slides on the substrate when the setting end is pressed in the axial direction of the probe pin. The plurality of springs are arranged parallel to each other, and the fixed ends of the springs are formed monolithically. The movement of the base of the probe pin in the direction perpendicular to the axis of the probe pin may be limited by the guide structure. That is, there is a gap formed between the guide and each probe pin. This gap allows the probe pin to start bending, while the tip and the base are fixed, when the tip of the probe pin is pressed in the axial direction. The gap also allows the tip of the probe pin to move in a direction perpendicular to the axial direction when the bending probe pin comes into contact with the guide. The guide has a plurality of holes, through which the probe pins penetrate, and the inner diameter of each hole is about 1.1 to 1.3 times as large as the outer diameter of the probe pin.

In another aspect of the invention, a probe used to detect the electrical properties of an electric device is provided. The probe comprises a flexible substrate holding a plurality of transfer lines having a specific line impedance, each transfer line comprising a signal line for transferring a prescribed electric signal and a feedback line extending parallel to the signal line and keeping the voltage constant. A plurality of through-holes are formed in the flexible substrate along an edge of the substrate, and one end of each of the signal lines extends to the through-holes. A conductive material is provided in the through-holes and electrically connected to the signal lines. A plurality of probe pins are inserted in the through-holes, and fixed to the through-holes so as to be substantially perpendicular to the transfer lines. The probe pins are electrically connected to the conductive material. The flexible substrate holds a plurality of pair-transfer lines, each consisting of a signal line for supplying the prescribed electric signal, and a feedback line electrically connected to the signal line in the vicinity of the edge of the substrate. At least some of the plurality of pair-transfer lines are parallel to each other, and the flexible substrate has slits between any two adjacent pair-transfer lines extending parallel to each other. The probe pins are fixed to and electrically connected with the conductive material.

In still another aspect of the invention, a semiconductor tester for testing the electrical properties of an electric device using a plurality of probes is provided. Each of the probes comprises a plurality of probe pins, each in mechanical contact with one of the electrical terminals of the electric device, and a controller for inspecting the electrical property of the electric device by supplying a prescribed electric signal to the probe pins. The semiconductor tester may further comprise a shifting mechanism for moving the probes in a direction perpendicular to the axial direction of the probe, while keeping the probes in mechanical contact with the electrical terminals. The probe pins also move in the direction perpendicular to the line along which the probes are arranged. The shifting mechanism moves the probes in the direction perpendicular to the axial direction of the probes when the probes are pressed against the electric terminals.

The present invention is not limited to the features described above. Any combinations of these features are also included in the invention.

### BRIEF DESCRIPTION OF THE DRAWINGS

The above and other objects, features, and advantages of the invention will be apparent from the following detailed description with reference to the attached drawings, wherein:
Fig. 1 illustrates the basic structure of a conventional cantilever type probe card;
Fig. 2 illustrates the basic structure of a conventional membrane type probe card;
Fig 3 is a cross-sectional view of the probe card according to the first embodiment of the present invention;
Fig. 4 is a partially enlarged view of the probe card shown in Fig. 3;
Fig. 5 is a perspective view showing how the probe pin 135 is connected to the flexible printed circuit board 138;
Fig. 6 is a perspective view of a probe pin 135 which is to be inserted into a through hole of the flexible printed circuit board 138;
Fig. 7 is a cross-sectional view of the flexible printed circuit board 138;
Fig. 8 illustrates how the tip 54 of the probe pin 135 moves horizontally on the electrical terminal 11 of the semiconductor device 10 being tested;
Fig. 9 is a plan view of a comb spring 87 as an example of the elastic member;
Fig. 10 is a partially enlarged view of the comb spring 87 shown in Fig. 9;
Fig. 11 is a cross-sectional view of the comb spring 87 shown in Fig. 9;
Fig. 12 illustrates a modification of the probe-pin shifting mechanism;
Fig. 13 illustrates another modification of the probe-pin shifting mechanism;
Fig. 14 illustrates a semiconductor device 10 suitable for the present invention;
Fig. 15 illustrates the probe-pin shifting mechanism according to the second embodiment of the invention;
Fig. 16 illustrates the probe pins, one of which is in contact with an electrical terminal 11 of the semiconductor device 10;
Fig. 17 illustrates two of the probe pins, one of which is bending;
Fig. 18 is a modification of the probe-pin shifting mechanism shown in Fig. 15;
Fig. 19 is another modification of the probe-pin shifting mechanism according to the second embodiment of the invention.

### DETAILED DESCRIPTION OF THE PREFERRED EMBODIMENTS

The preferred embodiments of the invention will now be described in detail. These embodiments do not limit the invention defined by the appended claims, and not all combinations of the features described in the embodiments are necessarily essential to the invention for overcoming the problems in the prior art.

### 1. First Embodiment

Fig. 3 is a cross-sectional view of the probe card according to an embodiment of the invention. The probe card comprises a printed circuit board 132, which is an example of the substrate. The printed circuit board 132 supports a plurality of probe pins 135, springs 139, and flexible printed circuit boards 138. The springs 139 and the flexible printed circuit boards 138 comprise a probe-pin shifting mechanism. Electric signals for testing a semiconductor device 10 are transferred to the semiconductor device 10 via interconnection patterns 120, flexible printed circuit boards 138, probe pins 135, and electrical terminals 11 formed on the semiconductor device 10. The printed circuit board 132 is a flat plate having a thickness of 1mm to 10mm, and it is reinforced by a reinforcement board 131 on the top surface, which is the surface further from the prober stage 136. A support frame 133 having an aperture in the center is fixed to the bottom face of the printed circuit board 132, which faces the prober stage 136. A base disc 137 having a thickness of about 0.7mm is also attached to the center of the bottom face of the printed circuit board 132. A plurality of V-shaped springs 139 are attached to the base disc 137 in such a manner that only one of the two top ends of each spring 139 is fixed onto the bottom face of the base disc 137. At least some of the plurality of probe pins 135 are arranged in a straight line perpendicular to the axial direction of the probe pins 135.

Fig. 4 is an enlarged view of the probe card shown in Fig. 3. The tip 54 of each probe pin 135 vertically comes into contact with the associated electrical terminal 11 (Fig. 3) of the semiconductor device 10. The diameter of the probe pin 135 is about 50 µm, and its inductance is about 5nH (nanohenry). A guide 134, which is made of ceramic and has a plurality of through-holes, is fixed to the support frame 133. The inner diameter of the through-holes is about 1.1 to 1.3 times larger than the outer diameter of the probe pin 135, and it is preferably 60 µm. Each probe pin 135 penetrates through one of the through-holes, and the guide 134 grasps each probe pin 135 at a position between the tip 54 and the base of each probe pin 135 in a slidable manner. Each probe pin 135 also penetrates through the flexible printed circuit board 138, and is fixed to a spring 139, which is a part of the probe-pin shifting mechanism, by plating or soldering. Each probe pin 135 is also soldered to the flexible printed circuited board 138 between the guide 134 and the spring 139. The spring 139 has a fixed end 14, which is fixed to the base disc 137 by an adhesive, and a setting end 76 for receiving the base of the probe pin 135. The interconnection pattern (that is, the circuit pattern) 120 formed on the printed circuit board 132 is connected to the associated flexible printed circuit board 138 via the pad 13 and the elastic connector 28.

The spring 139 has a V-shaped middle part 62 extending obliquely with respect to the axis of the probe pin 135 between the fixed end 14 and the setting end 76. The other end, opposite the fixed end 14 and opposite the setting end 76, is a sliding end 16. When the tip 54 of the probe pin 135 is pressed up by the electrical terminal 11 (Fig. 1) in the axial direction, the middle part 62 stretches horizontally, and the setting end 76 and the sliding end 16 slide in the lateral direction. Thus, the spring 139 causes the tip 54 of the probe pin 135 to shift laterally a distance corresponding to the distance of the vertical movement of the probe pin 135. The shifting direction is the longitudinal direction of the spring 139, and it is perpendicular to both the axial direction of the probe pin 135 and the straight line along which the probe pins are arranged. A plurality of springs 139 are arranged in a line so as to be parallel to each other, each corresponding to one of the probe pins 135.

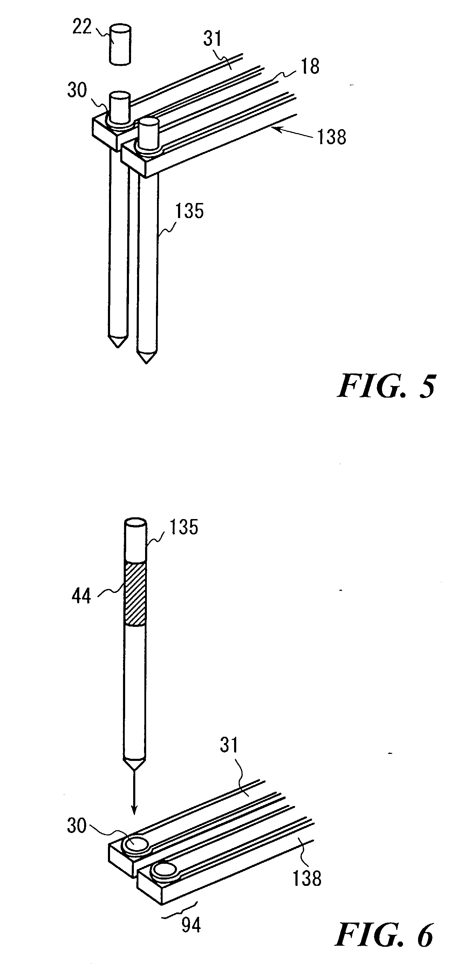

Fig. 5 is a perspective view showing how the probe pins 135 are connected to the flexible printed circuit boards 138. The flexible printed circuit board 138 is made of polyimide film, and has a thickness of about 10 µm to 70 µm, and a width of about 60 µm to 70 µm. A signal line 31 having a length of about 30mm is formed on the top surface of the flexible printed circuit board 138. The signal line 31 transfers an electric signal, which is used for testing the electrical properties of the semiconductor device 10, between the probe pin 135 and the printed circuit board 132 (Fig. 3). A plurality of signal lines extend in parallel to each other on the flexible printed circuit board 138. The flexible printed circuit board 138 has slits between any two adjacent signal lines 31, so that the probe pins 135 can independently move up and down in the axial direction. Each probe pin 135 is inserted into the associated through-hole 30 of the flexible printed circuit board 138, and soldered. Then, the unnecessary top portion of the electrode (probe pin) 22, which projects upward from the flexible printed circuit board 138, is cut off in order to make the length of all the probe pins 135 uniform.

Fig. 6 shows how the probe pin 135 is inserted into the through-hole 30 of the flexible printed circuit board 138. The part of the probe pin 135 which will be in contact with the through-hole 30 is covered with nickel-gold (Ni-Au) plating in advance, for the purpose of improving the electrical conductivity of the signal line 31. Then, the probe pin 135 is inserted into the through-hole 30, and soldered to the flexible printed circuit board 138. This arrangement reduces noise in the electric signal, which allows highly reliable measurement data to be obtained.

Fig. 7 is a cross-sectional view of the flexible printed circuit board 138. While a signal line 31 is provided on the top surface of the flexible printed circuit board 138, a feedback line 32, such as a ground lead (GND), is provided on the bottom surface. The signal line 31 and the feedback line 32 are preferably made of a highly conductive material, such as copper, and they are insulated from each other by a polyimide layer inserted between them. The thickness of the signal line 31 and of the feedback line 32 is about 10 µm, and the thickness of the center polyimide layer is 12.5 µm to 50 µm. The signal line 31 and the feedback line 32 comprise a transfer line 29. The feedback line 32 reduces the line impedance of the signal line 31, whereby the signal-transfer speed can be increased. The signal line 31 extends through the through-hole 30, and reaches the bottom surface of the flexible printed circuit board 138. The width of the signal line 31 which surrounds the through-hole 30 on the bottom surface of the flexible printed circuit board 138 is set to 30 µm. There is a space of about 60 µm between the signal line 31 and the feedback line 32 on the bottom surface of the flexible printed circuit board 138. The part of the, e.g., copper signal line 31 positioned in the through-hole 30 is covered with nickel-gold (Ni-Au) plating in order to improve the conductivity. The signal line 31 and the probe pin 135 are soldered onto both surfaces of the flexible printed circuit board 138 around the probe pin 135. This arrangement reduces noise in the electric signal, whereby highly reliable data can be obtained.

Fig. 8 illustrates how the tip 54 of the probe pin 135 slides on the electrical terminal 11. When the tip 54 of the probe pin 135 is pressed up by the electrical terminal 11, the V-shaped spring 139 is flattened with the sliding end shifting horizontally. At this time, the base of the probe pin 135 also moves horizontally, parallel to the top surface of the prober stage 136. Then, the probe pin 135 comes into contact with the guide 134 in the guide hole, and the tip 54 of the probe pin 135 moves in the lateral direction opposite that in which the base moves, with the point of contact with the guide as a fulcrum. The reason for rubbing the tip 54 of the probe pin 135 against the electrical terminal 11 is that as the test is repeated, grains of the electrical terminal 11 become attach to the tip of the probe pin 135, which interrupts the electrical contact between the probe pin 135 and the terminal 11. In order to remove these grains, the tip 54 of the probe pin 135 is rubbed slightly against the electrical terminal 11. As the tip 54 of the probe pin 135 moves horizontally on the electrical terminal 11, the tip 54 and the electric terminal 11 rub each other, and they can connect with each other with a low contact resistance without causing a bad connection between the electrical terminal 11 and the probe pin 135.

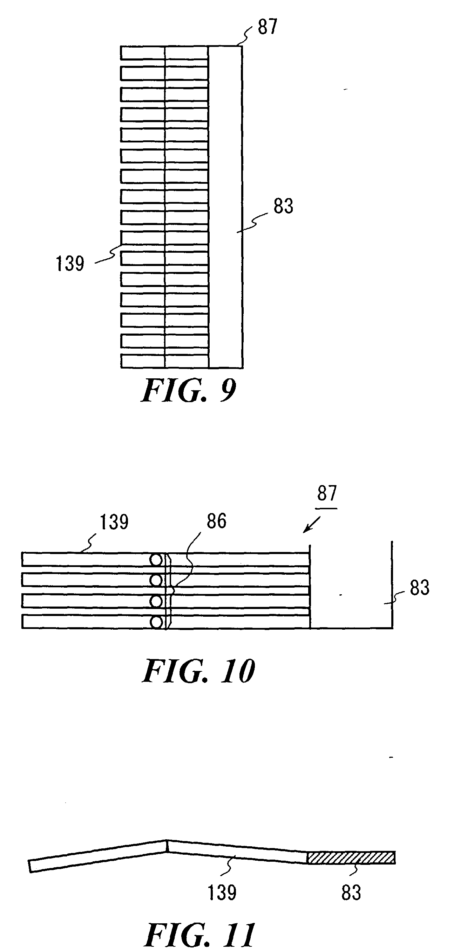

Fig. 9 is a plan view of a comb spring 87 in which a plurality of springs 139 are monolithically formed. The comb spring 87 comprises a plurality of springs 139 and a flat base area 83 from which the springs 139 extend. Fig.10 is a partially enlarged view of the comb spring shown in Fig. 9. A guide hole 86 for receiving a probe pin 135 is formed in the middle of each spring 139. Fig. 11 is a cross-sectional view of the comb spring 87 shown in Fig. 10. The flat base area 83 is fixed to the base disc 137 (Fig. 4) by an adhesive or the like. The spring 139 bends at the middle into a gentle chevron. When the probe pin 135 fixed in the middle is pressed, the chevron flattens and the probe pin moves in the lateral direction. With this structure, a plurality of springs 139 can easily be manufactured.

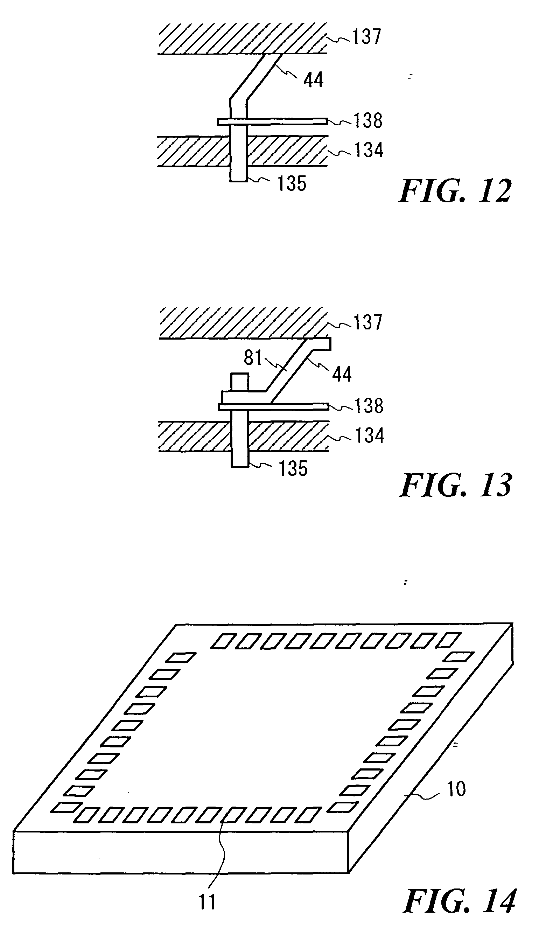

Fig. 12 illustrates a modification of the probe-pin shifting mechanism. The base of the probe pin 135 is connected to the base disc 137 by an adhesive in such a manner that the probe pin 135 extends from the base obliquely making an angle of about 40° to 50° with the base disc 137. The probe pin 135 bends at a position 70 µm above the flexible printed circuit board 138 toward a point directly above the guide hole of the guide 134. The probe pin 135 penetrates through the flexible printed circuit board 138 and the guide hole of the guide 134. Since the probe pin 135 is elastic, the obliquely extending upper part of the probe pin 135 stretches when the probe pin is pressed vertically, and it moves in the lateral direction. As a result, the tip 54 of the probe pin 135 shifts horizontally as in the structure shown in Fig. 3. This arrangement allows the probe pin 135 and the electrical terminal 11 (Fig. 8) to rub each other without using a spring 139.

Fig. 13 illustrates another modification of the probe-pin shifting mechanism. The base of a Z-shaped spring 81, which bends in two directions, is fixed to the base disc 137. The probe pin 135 penetrates through the guide hole of the guide 134, the through-hole formed in the flexible printed circuit board 138, and the Z-shaped spring 81. The tip of the Z-shaped spring 81 is fixed to the probe pin 135 by an adhesive, while the base is fixed to the base disc 137 by an adhesive. When the probe pin 135 is pressed against the electrical terminal 11, the middle portion of the spring 81, which extends obliquely with respect to the base disc 137, stretches, and the position of the base of the probe pin 135 moves horizontally, which causes the tip of the probe pin 135 to shift laterally in the opposite direction. As a result, the tip of the probe pin 135 and the electrical terminal 11 rub each other.

Fig. 14 illustrates a semiconductor device 10 which is suited to be tested by the probe card and the probe pin 135 according to the invention. In this device 10, electrical terminals 11 are aligned along the four sides. Each electrical terminal 11 is a rectangle having a width extending parallel to the associated side which is shorter than the length extending perpendicular to that side, so as to increase the number of electrical terminals 11 that can be lined up along a side of given length. The probe pin 135 of the probe card of the invention rubs the electrical terminal 11 in a predetermined direction. In this example, the probe card is designed so that the tip of the probe pin 135 rubs the top surface of the electrical terminal 11 in the direction perpendicular to the associated side in order to obtain an adequate length for rubbing. Although this figure illustrates a single semiconductor device, the probe card and the probe pin 135 according to the invention can be used to test a semiconductor wafer consisting of a plurality of semiconductor devices 10. Thus, in this context, the term "semiconductor device" includes both a single semiconductor device and a semiconductor wafer consisting of a plurality of semiconductor devices.

By arranging the electrical terminals as shown in Fig. 14, the probe pin 135 reliably remains in contact with the electrical terminal 11 even after the rubbing. In contrast, with the conventional probe card, the probe pins 135 rub the electrical terminals 11 in random directions and, accordingly, the dimensions of the electrical terminal 11 must be sufficiently large in both directions in order to allow the probe pins 135 to remain in contact. In the present invention, the tip of the probe pin 135 is prevented from shifting in the width (i.e., shorter) direction of the electrical terminal 11, allowing the electrical terminals 11 to be arranged on the semiconductor device 10 with a higher density. Although, in Fig. 14, the electrical terminals 11 are positioned only along the four sides, they may be arranged in a lattice. In this case, for each electrical terminal 11, the length in the direction of rubbing, is again set longer than the other side (i.e., the width) in order to be able to increase the density of the electrical terminals 11 on the semiconductor device 10. Examples of such semiconductor devices are listed below.
1. A semiconductor device having a desired integrated circuit pattern formed on it, in which at least some of the electrical terminals which are to be in mechanical contact with a test probe are arranged in a straight line, the length of each electrical terminal extending in the direction perpendicular to that line being longer than the width extending parallel to that line.
2. A semiconductor device having a square top surface with a desired integrated circuit pattern formed on it, in which electrical terminals which are to be in mechanical contact with a test probe are arranged along the four sides, the length of each electrical terminal extending perpendicular to the associated side being longer than the width extending parallel to the associated side.
3. A semiconductor device having a desired integrated circuit pattern formed on it, in which electrical terminals which are to be in mechanical contact with a test probe are arranged in a two-dimensional matrix, the pitch of the two-dimensional matrix in one direction being longer than that in the direction perpendicular to said one direction, and the length of each electrical terminal extending in said one direction being longer than the width extending in said perpendicular direction.

### 2. Another Embodiment

In the first embodiment, the tip of the probe pin 135 is moved along the top surface of the electrical terminal 11 by moving the base of the probe pin 135. In the present embodiment, the probe pin 135 itself bends with its base firmly fixed, thereby allowing the tip 54 to sweep the surface of the electrical terminal 11.

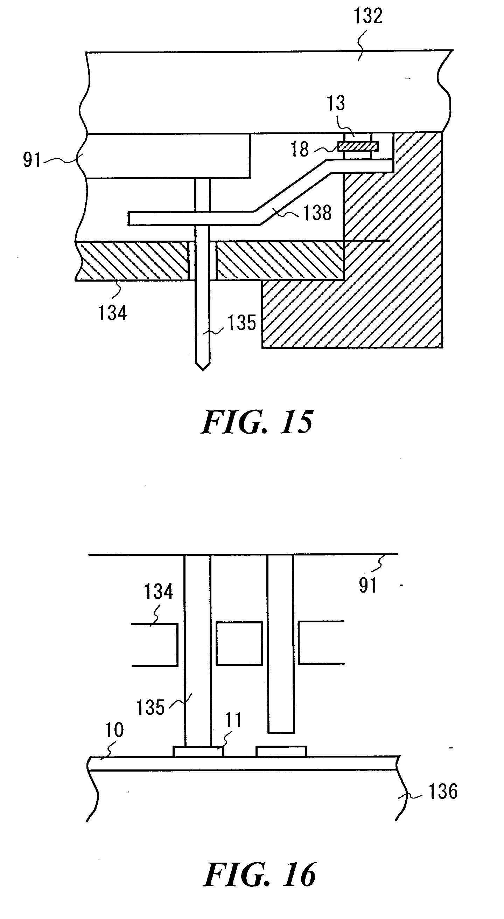

Fig. 15 is a cross-sectional view of the probe-pin shifting mechanism according to this embodiment. In this embodiment, an elastic rubber 91 is used as an elastic member in place of the spring 139 and the base disc 137 used in Fig. 3. The rest of the structure is the same as that shown in Fig. 3, and the explanation for it will therefore be omitted. The tip 54 of the probe pin 135 is pressed against the electrical terminal 11, making use of the elasticity of the rubber 91. Since the base of the probe pin 135 is fixed, the tip 54 sweeps in response to the bending force, and rubs the top surface of the electrical terminal 11.

Fig. 16 shows that while a given probe pin 135 in contact with the electrical terminal 11, another probe pin 135 may not be in contact with the electrical terminal 11 because there is an uncertainty in the distance between the tip 54 of the probe pin 135 and the electrical terminal 11. To compensate fo this uncertainity, the prober stage 136 is sufficiently elevated toward the probe pin 135 of the probe card so that all the probe pins are pressed against the electrical terminals 11. This operation, in which the electrical terminals 11 are further elevated even after some of them have come into contact with the tips 54 of the probe pins 135, is called an overdrive.

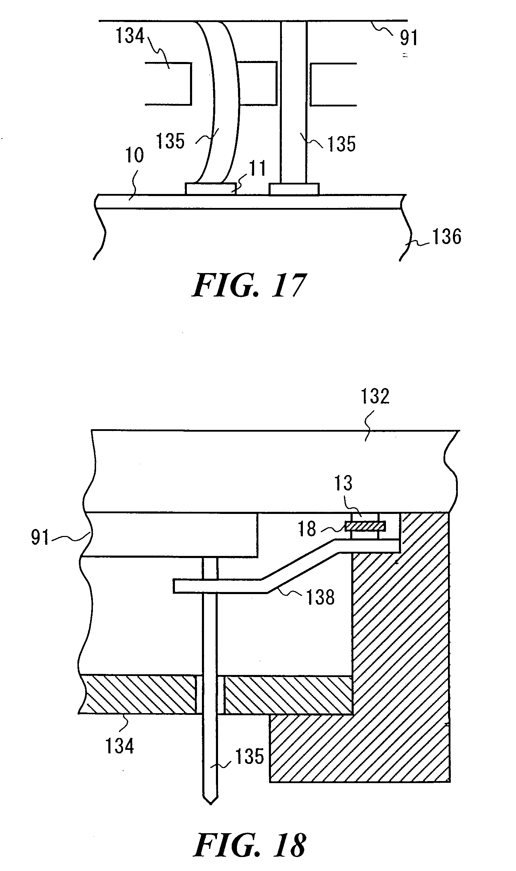

Fig. 17 illustrates a probe pin 135 which is bending between the rubber 91 and the electrical terminal 11, while another probe pin 135 has just come into contact with the electrical terminal 11, as a result of the overdrive. As the tip 54 of the probe pin 135 is pressed against the electrical terminal 11 during overdrive, the probe pin 135 bends and the crest comes into contact with the guide 134. If the trunk of the probe pin 135 is still further pressed against the guide 134, the guide 134 presses the probe pin 135 back and, as a result, the tip 54 of the probe pin 135 moves in the direction perpendicular to the axial direction of the probe pin 135 away from the point of contact of the guide 134 and the trunk of the probe pin 135. In this arrangement, a gap is provided between the guide 134 and each probe pin 135. The size of the gap is set so that the guide 134 can appropriately press back the bending probe pin 135.

Fig. 18 shows a modification of the probe card shown in Fig. 15. In Fig. 18, the flexible printed circuit board 138 has been shifted away from the guide 134, and positioned closer to the elastic rubber 91. Because no feedback line is provided to the probe pin 135, the line impedance increases as the length of the probe pin 135 increases. In order to overcome this problem, the flexible printed circuit board 138 is positioned as close to the rubber 91 as possible so that the flexible printed circuit board 138 will not prevent the probe pin 135 from bending. In this arrangement, the tip 54 of the probe pin 135 can reliably be made sweep and rub against the top surface of the electrical terminal 11.

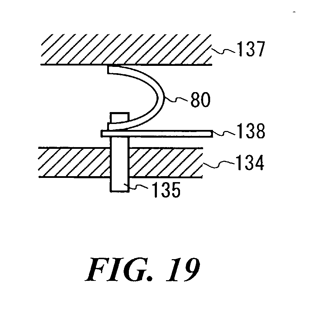

Fig. 19 illustrates a modification of the elastic member. In this example, a U-shaped spring 80 is used in place of the elastic rubber 91 shown in Fig. 15. The U-shaped spring 80 is positioned between the base disc 137 and the guide 134. The probe pin 135 penetrates through the guide hole formed in the guide 134, the through-hole formed on the flexible printed circuit board 138, and the U-shaped spring 80. One end of the U-shaped spring 80 is fixed to the base plate 137 by an adhesive, and the other end is connected to the probe pin 135 by plating or soldering. The elastic modulus of the U-shaped spring 80 is relatively large. Accordingly, when the probe pin 135 is pressed against the electrical terminal 11, the probe pin 135 bends. This bending force causes the tip 54 of the probe pin 135 to sweep the surface of the electrical terminal 11.

As has been described, the probe pin 135 efficiently rubs against the top surface of the electrical terminal 11 of the semiconductor device 10 being tested. Consequently, the semiconductor device 10 can be reliably tested without causing any interruption of the connection between the probe pin 135 and the electrical terminal 11.

Although the invention has been described by way of exemplary embodiments, it should be understood that many changes and substitutions may be made by those skilled in the art without departing from the spirit and the scope of the invention, which is defined only by the appended claims. This patent application claims priority based on a Japanese patent application filed on June 2, 1998, the contents of which are hereby incorporated by reference.

## Claims

1. A probe card for testing electrical properties of an electric device having a plurality of terminals (11) by mechanically being brought into contact with the terminals (11) of the electric device, the probe card characterized in that:
a plurality of probe pins (135) having tips (54) which come into contact with the terminals (11) of the electric device;
an elastic member (80, 81, 91, 139) causing the tips (54) of the probe pins (135) to spring back in an axial direction of the probe pins (135) when the tips (54) of the probe pins (135) are pushed against the terminal (11);
a plurality of transfer lines (29) for supplying and receiving signals to and from the probe pins (135) when the probe pins (135) are in contact with the terminals (11); and
a substrate (132, 138) for holding the probe pins and the transfer lines (29).

2. A probe card according to claim 1, further characterized in that at least some of the plurality of probe pins (135) are arranged in a straight line on the probe card.

3. A probe card according to claim 1, further characterized by comprising a probe-pin shifting mechanism for moving the tip (54) of the probe pin (135) in a direction perpendicular to the axial direction of the probe pin (135) a distance corresponding to a distance the probe pin (135) moves in the axial direction when the probe pin (135) is pushed against the associated terminal (11).

4. A probe card according to claim 3, further characterized in that the probe-pin shifting mechanism moves the tip (54) of the probe pin (135) in a predetermined direction when the probe pin (135) is pushed against the terminal (11).

5. A probe card according to claim 4, further characterized in that at least some of the plurality of probe pins (135) are arranged in a straight line on the probe card.

6. A probe card according to claim 5, further characterized in that said predetermined direction is perpendicular to both the axial direction of the probe pin (135) and the straight line in which the probe pins (135) are arranged.

7. A probe card according to claim 3, further characterized in that the transfer line (29) has a signal line (31) having a specific line impedance that allows an electric signal to propagate through, and a feedback line (32) extending parallel to the signal line (31).

8. A probe card according to claim 3, further characterized in that at least a portion of the transfer line (29) has a pair-line structure having a signal line (31) for supplying an electric signal and a feedback line (32) connected to the signal line (31) near the probe pin (135).

9. A probe card according to claim 3, further characterized in that one transfer line (29) is provided to one probe pin (135).

10. A probe card according to any one of claims 3 through 6, further characterized in that:
the probe pin (135) further has a base; and
the probe-pin shifting mechanism comprises:
a guide (134) for grasping the probe pin (135) between the base and the tip (54) in a slidable manner; and
a spring (139) corresponding to the probe pin (135) having a fixed end (14) fixed to the substrate (132) and a setting end (76) for receiving the base of the probe pin (135), the setting end (76) shifting in a direction perpendicular to the axial direction of the probe pin (135) when a force is applied to the setting end (76) in the axial direction of the probe pin (135).

11. A probe card according to claim 10, further characterized in that the base of the probe pin (135) is fixed to the associated spring (139).

12. A probe card according to claim 10, further characterized in that the spring (139) further has a spring portion (62) extending between the fixed end (14) and the setting end (76) and stretching in the axial direction of the probe pin (135).

13. A probe card according to claim 10, further characterized in that:
the spring (139) further has a sliding end (16) which is opposite the fixed end (14); and
the sliding end (16) slides on the substrate (132) when the setting end (76) is pushed in the axial direction of the probe pin (135).

14. A probe card according to claim 10, further characterized in that the plurality of springs (139) are arranged in parallel, and the fixed ends (76) of the springs are formed monolithically.

15. A probe card according to any one of claims 3 through 6, further characterized in that:
the probe pin (135) has a base whose movement in the direction perpendicular to the axial of the probe pin (135) is limited;
the probe-pin shifting mechanism has a guide (134) for grasping the probe pin (135) between the tip (54) and the base in a slidable manner and a gap provided between the guide (134) and the probe pin (135) for allowing the probe pin (135) to bend, when the tip (54) and the base of the probe pin (135) are fixed and the tip (54) is pushed against the terminal (11) in the axial direction, and for further allowing the tip (54) of the probe pin (135) to move in a direction perpendicular to the axial direction after the bending probe pin (135) comes into contact with the guide (134).

16. A probe card according to claim 15, further characterized in that the guide (134) has a plurality of guide holes, through which the probe pins (135) penetrate, and the inner diameter of the guide hole is about 1.1 to 1.3 times as large as the outer diameter of the probe pin (135).

17. A probe for detecting electrical properties of an electric device having electrical terminals (11) by mechanically being brought into contact with the electrical terminals (11) to supply a prescribed electric signal, the probe characterized by comprising:
a flexible substrate (138) holding a plurality of transfer lines (29) having a specific line impedance, the transfer line (29) having a signal line (31) for transferring the prescribed electric signal and a feedback line (32) extending parallel to the signal line (31) and keeping a constant electric potential;
a plurality of through-holes (30) formed along an edge of the flexible substrate (138), to which one end of the signal line (31) extends;
a conductive material provided in the through-holes (30) and electrically connected to the signal lines (31); and
a plurality of probe pins (135) inserted in and fixed to the through-holes (30) so as to be substantially perpendicular to the associated transfer line (29) and electrically connected to the conductive material.

18. A probe according to claim 17, further characterized in that the flexible substrate (138) holds a plurality of pair-transfer lines (29), having a signal line (31) for supplying the prescribed electric signal, and a feedback line (32) electrically connected to the signal line (31) in the vicinity of the edge of the substrate (138).

19. A probe according to claim 17, further characterized in that:
at least one of the plurality of pair-transfer lines (29) is parallel to other pair-transfer line; and
the flexible substrate (138) has slits between any two adjacent and parallel pair-transfer lines.

20. A probe according to claim 17, further characterized in that the probe pin (135) is fixed to and electrically connected with the conductive material.

21. A semiconductor testing apparatus comprising a plurality of probes for testing electrical properties of an electric device, characterized in that the probe comprises:
a plurality of probe pins (135), which comes into contact with electrical terminals (11) of the electric device;
an elastic member (139) for causing the probe pins (135) to spring back when the probe pins (135) are pushed against the electrical terminals (11) in the axial direction of the probe pin (135); and
a controller for examining the electrical properties of the electric device by supplying a prescribed electric signal to the probe pins (135).

22. A semiconductor testing apparatus according to claim 21, further characterized by comprising a shifting mechanism for moving the probe pins (135) in a direction perpendicular to the axial direction of the probe pins (135), while keeping the probes in mechanical contact with the electrical terminals (11).

23. A semiconductor testing apparatus according to claim 22, further characterized in that the probe pins (135) move in a direction perpendicular to the line in which the probe pins (135) are arranged.

24. A semiconductor testing apparatus according to claim 23, further characterized in that the shifting mechanism moves the probe pins (135) in a direction perpendicular to the axial direction of the probe pins (135) when the probe pins (135) are pushed against the electric terminals (11).

25. A probe card for testing electrical properties of a electric device having a plurality of terminals (11) by mechanically being brought into contact with the terminals (11) of the electric device.

26. A probe for detecting electrical properties of an electric device having electrical terminals (11) by mechanically being brought into contact with the electrical terminals (11) to supply a prescribed electric signal.
